# EUROPEAN PATENT SPECIFICATION

(11) **EP 2 946 031 B1**
(45) Date of publication and mention of the grant of the patent: **14.08.2024**
(21) Application number: 14741009.6
(22) Date of filing: 15.01.2014
(51) Int. Cl.: C25D 3/06, C23C 28/02, C25D 5/50, C25D 5/14, C23C 18/18, C23C 18/16, C23C 18/36, C23C 12/00, C23C 12/02, C23C 28/00, C25D 5/00

(54) **METHOD FOR PRODUCING A CHROMIUM COATING ON A METAL SUBSTRATE**
VERFAHREN ZUR HERSTELLUNG EINES CHROMATBELAGS AUF EINEM METALLSUBSTRAT
PROCÉDÉ DE PRODUCTION D'UN REVÊTEMENT DE CHROME SUR UN SUBSTRAT MÉTALLIQUE

(30) Priority: 15.01.2013 WO PCT/FI2013/050038
(43) Date of publication of application: 25.11.2015
(73) Proprietor: Savroc Ltd, 70620 Kuopio (FI)
(72) Inventor: MIETTINEN, Juha, FI-70870 Hiltulanlahti (FI); RÄISÄ, Jussi, FI-70840 Kuopio (FI)
(74) Representative: Papula Oy
(86) International application number: PCT/FI2014/050029
(87) International publication number: WO 2014/111624

(56) References cited:
- EP-A2- 0 446 762
- WO-A1-2007/007790
- WO-A1-2011/105392
- JP-A- 2011 179 078
- US-A- 3 164 897
- US-A- 5 413 646
- MU, S. ET AL.: "Investigation of a transparent chromate (III) passive film on electroless NiP coating by XPS and electrochemical methods", ELECTROCHIMICA ACTA, vol. 54, no. 26, 1 November 2009 (2009-11-01), pages 6718 - 6724

## Description

### FIELD OF THE INVENTION

The invention relates to a method for producing a trivalent chromium based coating on a metal substrate.

### BACKGROUND OF THE INVENTION

Chromium coating is widely used as a surface coating for metal articles because of its high hardness value, attractive appearance and superior wear and corrosion resistance. Traditionally, Cr deposition is accomplished by electroplating from an electrolytic bath containing hexavalent Cr ions. The process is highly toxic in nature. Lots of efforts have been made to develop alternative coatings and coating processes to replace hexavalent Cr in electroplating. Among those alternative processes, trivalent Cr electroplating seems to be attractive due to its low cost, convenience of fabrication through the use of environmental friendly and non-toxic chemicals, and ability to produce a bright Cr deposit. However, an industrial scale process giving a hard and corrosion resistant Cr deposit through an aqueous trivalent chromium solution is still missing. Among the industry, there is a hectic need for a well manageable and easy to use trivalent Cr based coating process to replace the current use of hexavalent Cr in coating.

Electroless deposition of nickel has also been proposed as an alternative to hard chromium plating. Drawbacks of Ni electroless deposition include deficiencies in hardness, friction coefficient, wear and corrosion resistance and adhesion. Electroless nickel and functional chromium are not interchangeable coatings. The two have unique deposit properties and, therefore, each has its distinct applications.

It is well known in the art that the hardness of a chromium coating can be improved, to some extent, by thermal treatment. According to P. Benaben, An Overview of Hard Cromium Plating Using Trivalent Chromium Solutions, http://www.pfonline.com/articles/an-overview-of-hard-chromium-plating-using-trivalent-chromium-solutions, the microhardness of a chromium deposit as-plated is about 700-1000 HV₁₀₀. By a heat treatment at 300-350°C the microhardness of trivalent Cr can be increased up to about 1700-1800 HV₁₀₀. At higher temperatures the hardness of the Cr deposit tends to decrease. Adhesion of a trivalent Cr layer is known to cause problems. The process chemistry of known trivalent Cr baths is often very complicated and hard to manage.

US 5271823 A discloses a method for providing a wear resistant Cr coating on a metal object, including the steps of electrodepositing a coating made solely from trivalent Cr ions and devoid of hexavalent Cr ions on the object and heating the coating to a temperature of at least 66°C for at least 30 minutes.

US 5413646 A discloses a method for electroplating a workpiece, comprising the steps of providing a plating bath comprising trivalent Cr produced by reducing a Cr(VI) compound to Cr(III) compound with methanol or formic acid, providing an anode in the plating bath, placing the workpiece in the bath to act as a cathode, electroplating a chromium and iron metal layer onto the workpiece, and heating the workpiece from about 316°C to about 913°C for a sufficient period of time to harden the workpiece while retaining or increasing the hardness of the chromium alloy plated on the workpiece.

US 6846367 B2 discloses a heat-treating method for improving the wear and corrosion resistance of a chromium-plated steel substrate, comprising the steps of plating a chromium layer onto an steel substrate and heating the chromium-plated steel substrate in an oxidizing gas environment at above atmospheric pressure to form oxidized layers containing magnetite (Fe₃O₄) on the surface of the steel substrate, the surface of the steel substrate being partly exposed to the air through penetrating cracks formed in the chromium layer.

US 7910231 B2 discloses a method for producing a coated article comprising a substrate and a coating on the substrate, the coating comprising chromium and phosphorus, Cr and P being present in at least one of the compounds CrP and Cr₃P. Phosphorus is brought into the coating as a part of the chromium solution, and the maximum hardness that can be reached after a heat treatment is 1400-1500 HV. The coating lacks nickel, as do all the other chromium coatings referred to above.

EP 0446762 A2 discloses a method for coating metal components. The method comprises coating a metal component with at least two metal or metal alloy layers for increasing corrosion resistance and the wear resistance of the metal component.

US 3164897 A1 discloses that metal surfaces may be joined by preplacing a brazing composition comprised of a major portion of nickel, a minor portion of phosphorus and a minor portion of chromium on said surfaces, and brazing together the resulting surfaces.

The hardness, friction coefficient, wear and corrosion resistance of known trivalent Cr coatings are not sufficient to satisfy the demands of industry. The coating processes of prior art are not capable of producing coatings with a Vickers microhardness value of about 2000 HV or more.

Apparently, there is a need in the art to find a cost-effective trivalent Cr electroplating method, which is able to yield such utmost mechanical properties that enable replacement of hexavalent Cr baths in industrial use.

### PURPOSE OF THE INVENTION

The purpose of the invention is to reduce and eliminate the problems faced in the prior art.

Another purpose of the invention is to offer a coating process that is able to yield high hardness values for a coated article.

A further purpose of the invention is to produce a trivalent Cr based coating having superior mechanical and chemical properties.

A still further purpose of the invention is to provide a coating with progressively increasing hardness of layers so that the coating is able to withstand surface pressure already at relatively low thicknesses. This brings about cost savings as a sufficient performance can be reached with thinner coatings and lower production costs.

### SUMMARY

The method according to the present invention is characterized by what is presented in claim 1.

The method according to the present invention comprises depositing a layer of nickel phosphorus alloy (Ni-P) on a metal substrate and electroplating a chromium layer from a trivalent chromium bath on the layer of Ni-P. After that the coated metal substrate is subjected to one or more heat treatments to amend the mechanical and physical properties of the coating and to produce multiphase layers including at least one layer containing crystalline Ni and crystalline Ni₃P and at least one layer containing crystalline Cr and crystalline CrNi.

According to one embodiment of the present invention, the method comprises an additional step of electroplating a nickel underlayer on the metal substrate before the step of depositing the Ni-P layer.

According to another embodiment of the present invention, the method comprises a step of depositing a layer of nickel between the Ni-P layer and the Cr layer.

According to one aspect of the invention, the method comprises two or more heat treatments of the coated metal substrate. The heat treatments can be carried out at the same temperature or at different temperatures.

The Ni-P layer can be deposited by electroless plating or electroplating.

The phosphorus content of the Ni-P alloy can be in the range of 1-20%. Advantageously, the phosphorus content is in the range of 3-12%, preferably 5-9%.

The thickness of the Ni-P layer can be in the range of 1-50 pm, preferably 3-30 pm.

The thickness of the Cr layer can be in the range of 0.05-100 µm, preferably 0.3-5 pm. When producing a decorative coating, the thickness of Cr layer is typically 0.3-1 um. When producing a technical coating, the thickness of Cr layer is typically 1-10 pm.

In one embodiment of the invention, the temperature in the first heat treatment is 200-500°C, preferably 350-450°C, and the temperature in the second heat treatment is 500-800°C, preferably 650-750°C.

In another embodiment of the invention, the temperature in the first heat treatment is 500-800°C, preferably 650-750°C, and the temperature in the second heat treatment is 200-500°C, preferably 350-450°C.

One embodiment of the present invention comprises producing a decorative and corrosion resistant coating on a metal substrate. In that case, the method comprises depositing a bright Ni layer on the metal substrate, depositing a Ni-P layer on the bright Ni layer and depositing a Cr layer by electroplating on the Ni-P layer, after which the coated metal substrate is subjected to heat treatment at 200-500°C for 15-30 minutes. Alternatively, said layers can be deposited in partly reversed order so that a Ni-P layer is deposited directly on the metal substrate, a bright Ni layer is deposited on the Ni-P layer and a Cr layer is deposited on the bright Ni layer.

Another embodiment of the present invention comprises producing a hard chrome coating on a metal substrate, in that case, the method comprises depositing a Ni-P layer on the metal substrate and depositing a trivalent Cr layer by electroplating on the Ni-P layer, after which the coated metal substrate is subjected to a first heat treatment at 650-750°C for 15-30 minutes and to a second heat treatment at 400-500°C for 15-30 minutes. The number of heat treatments can be higher than two.

One embodiment of the present invention comprises producing a multilayer coating by repeating at least once the steps of depositing a layer of nickel phosphorus alloy and electroplating a chromium layer from a trivalent chromium bath, after which the coated metal substrate is subjected to the said one or more heat treatments.

One embodiment of the present invention comprises depositing a strike layer on the layer of trivalent chromium before depositing a new layer of nickel phosphorus alloy. A strike layer can be used to improve the adhesion between two layers. The strike layer can consist of, for instance, sulphamate nickel, bright nickel, titanium, or any other suitable material.

The method can also comprise depositing an intermediate layer between the layers of Ni-P and Cr, the intermediate layer consisting of another metal or metal alloy or ceramic. Suitable metals are, for instance, copper and molybdenum. Suitable ceramics are, for instance, oxides, nitrides and carbides of different metals.

In one embodiment of the invention, at least one of the heat treatments is carried out at a temperature which leads to hardening of the metal substrate at the same time as the coating is hardened. In that case, the heat treatment can be carried out at a temperature of 750-1000° C, preferably 800-950° C.

It is also possible to once more harden a metal substrate that has already been subjected to hardening before coating.

Further, it is also possible to subject the coated object to annealing or tempering at a lower temperature after the object has been subjected to hardening at a higher temperature.

In one embodiment of the invention, a top layer is deposited on the coated metal substrate using thin film deposition. The top layer can be made of any suitable material that is able to give the coated surface the desired properties; for instance, the top layer can consist of metal, metal alloy or ceramic, such as titanium nitride, chromium nitride, or diamond like carbon (DLC). The thin film deposition technique to be used can be selected from the group comprising physical vapor deposition (PVD), chemical vapor deposition (CVD), atomic layer deposition (ALD), and physical-chemical deposition.

Heat treatment of coated metal substrate can be carried out, for instance, in conventional heat treatment furnaces. Alternatively, heat treatment can be carried out by processes based on induction heating, flame heating or laser heating. Induction heating is a no-contact process that quickly produces intense, localized and controllable heat. With induction, it is possible to heat only the selected parts of the coated metal substrate. Flame heating refers to processes where heat is transferred to the workpiece by means of a gas flame without the workpiece melting or material being removed. Laser heating produces local changes at the surface of the material while leaving the properties of the bulk of a given component unaffected. Heat-treating with laser involves solid-state transformation, so that the surface of the metal is not melted. Both mechanical and chemical properties of a coated article can often be greatly enhanced through the metallurgical reactions produced during heating and cooling cycles.

By means of a method according to the present invention it is possible to produce coatings having an excellent corrosion resistance and an extremely high and adjustable hardness (Vickers microhardness 1000-3000 HV). The coating process is safe and less toxic than hexavalent chromium containing processes.

### BRIEF DESCRIPTION OF THE DRAWINGS

The accompanying drawings, which are included to provide a further understanding of the invention and constitute a part of this specification, illustrate embodiments of the invention and together with the description help to explain the principles of the invention.
Fig. 1 is a bar chart showing the coating hardness as a function of time and temperature in the second heating step when the first step was carried out at 400°C.
Fig. 2 is a bar chart showing the coating hardness as a function of time and temperature in the second heating step when the first step was carried out at 700°C.
Fig. 3 is an example of EDS spectrum of a coating after a duplex heat treatment at 400°C and 700°C.
Fig. 4 is a graph showing a part of the XRD spectrum of the coating of Fig. 3.
Fig. 5 is an example of EDS spectrum of a coating after duplex heat treatment at 700°C and 400°C.
Fig. 6 is a graph showing a part of the XRD spectrum of the coating of Fig. 5.
Fig. 7 is a graph showing the XRD and GID spectra of a coating according to the present invention.
Fig. 8 is a graph showing two examples of possible heat treatment sequences.
Fig. 9 is a cross-sectional micrograph of a coated surface.
Fig. 10 is a graph showing a part of the XRD spectrum of a conventional coating.
Fig. 11 is a graph showing the friction coefficients of the new coating and of three reference coatings.

### DETAILED DESCRIPTION OF THE INVENTION

The metal substrate to be coated by the present method can be any metal article made of, for instance, steel, copper, bronze, brass, etc. Depending on the heat treatment sequence and temperature used, the new coating method can be used both in decorative chromium plating and hard chromium plating.

The metal substrate to be coated is first subjected to appropriate pretreatment steps, such as, for instance, chemical and/or electrolytic degreasing to remove oil and dirt from the surface to be coated, and pickling to activate the surface before the actual coating and plating steps.

If necessary, the pretreated metal substrate is then subjected to an optional nickel deposition step. In this step, the metal substrate is immersed into a suitable nickel bath, for instance a bath of nickel sulfamate, through which an electric current is passed, resulting in deposition of a Ni underlayer on the metal substrate. The procedure can be repeated as many times as necessary in case more than one Ni underlayer is needed. In connection with decorative chromium coating, a bright nickel bath can be employed to produce a bright and corrosion resistant Ni underlayer. The Ni underlayer can alternatively be produced by electroless deposition. The thickness of the Ni underlayer can be, for instance, 10-20 pm. In connection with hard chromium coating, a Ni underlayer can usually be omitted as no additional corrosion protection is needed.

Next, the metal substrate is subjected to electroless nickel-phosphorus deposition, whereby a Ni-P layer is chemically deposited on the Ni underlayer, or directly on the pretreated metal substrate when no Ni underlayer is needed. The Ni-P layer can be deposited, for instance, from a solution formulated with sodium hypophosphite as the reducing agent. This results in a nickel film that is alloyed with phosphorus in a range between 1 and 12%. Preferably, the Ni-P alloy deposited according to the present invention comprises phosphorus 5-9 wt-%. The thickness of the Ni-P layer can be 1-100 µm, preferably 3-30 pm. Alternatively, the Ni-P layer can be deposited by electroplating.

After deposition of the Ni-P layer, the metal substrate is subjected to trivalent chromium deposition by electroplating. Cr electroplating can be carried out by any suitable method that is industrially usable, for instance, in decorative Cr plating. One example of processes and electrolyte solutions that can be used is the one traded by Atotech Deutschland GmbH under the trade name Trichrome PlusO. This electrolyte solution comprises 20-23 g/l trivalent chromium ions and 60-65 g/l boric acid. The working parameters of the process are: pH 2.7-2.9, temperature 30-43°C, and cathodic current density 8-11 A/dm². The thickness of the Cr layer deposited can be 0.05-100 pm, preferably 1-10 pm.

Alternatively, a layer of bright nickel can be deposited on the NI-P layer before the step of Cr electroplating. This is favorable in particular in connection with decorative coatings.

After deposition of Cr layer, the coated metal article is subjected to one or more heat treatment sequences at a temperature between 200-1000°C for a selected period. Preferably, the process comprises two or more successive heat treatments, between which the coated metal substrate is cooled.

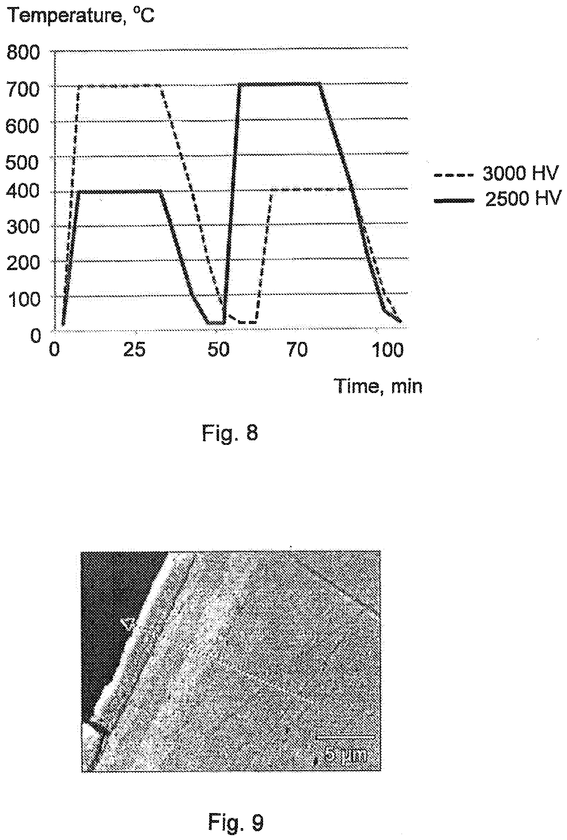

Fig. 8 shows the temperature as a function of time during two heat treatment sequences that are suitable for use in connection with the present invention. The solid line represents a heat treatment sequence comprising a first step at 400°C, followed by cooling and a second step at 700°C. In this case, hardness values of about 2500 HV can be reached. The broken line represents a heat treatment sequence comprising a first step at 700°C, followed by cooling and a second step at 400°C. In this case, hardness values of about 3000 HV can be reached.

Heat treatments can take place in a conventional gas furnace, by means of induction heating, laser heating, flame heating, or any other suitable heating method. After each heat treatment the metal substrate is cooled. Cooling can be carried out by quenching in water or any other cooling liquid or in open air. Cooling can also be carried out at gas atmosphere to adjust the coating color.

It has been noticed that improved surface properties, such as notably high hardness values, increased corrosion and wear resistance, and reduced friction coefficient, can be acquired by the heat treatment of the present multiphase coating. For instance, hardness values as high as 2500-3000 HV have been measured in the tests.

In decorative embodiments, such as lock elements made of brass, which need a good corrosion resistance, the structure of the coating can be, for instance, as follows: a layer of bright Ni with a thickness of 10 pm, a layer of Ni-P with a thickness of 3 pm, and a layer of trivalent Cr with a thickness of 1 pm. Heat treatments can comprise one single step of 15-30 minutes at 200-500°C.

In technical embodiments, such as shafts of hydraulic cylinders, the composition of the coating can be, for instance, as follows: a layer of Ni sulfamate with a thickness of 10 pm, a layer of Ni-P with a thickness of 7-20 pm, covered by a layer of trivalent Cr with a thickness of 4-10 pm. Heat treatments can comprise two steps, for instance a first step of 30 minutes at 600°C and a second step of 30 minutes at 400°C; or a first step of 30 minutes at 700°C and a second step of 30 minutes at 400 or 500°C.

### EXAMPLE 1

In order to demonstrate the efficacy of the present invention, several metal substrates were coated with nickel and chromium and subjected to duplex heat treatment sequence. The coated metal substrates used in the tests comprise a steel substrate covered by a Ni-P layer with a thickness of 7 µm and a Cr layer with a thickness of 4 pm.

The first heating step was carried out at a temperature between 200°C and 700°C for 30 or 45 minutes, after which the metal substrate was cooled. The second heating step of the same sample was carried out at a temperature between 400°C and 700°C with a duration between 5 and 30 minutes, after which the metal substrate was cooled again.

The hardness values of the coated and heat treated metal substrates was measured by Vickers hardness test in micro range using indenter weights of 5, 10 or 25 g depending on the thickness of the coating according to EN-ISO 6507.

The corrosion resistance of the coated and heat treated metal substrates was measured by Acetic Acid Salt Spray Test (AASS) according to SFS-EN ISO 9227.

The friction coefficients of the coated and heat treated metal substrates were measured with a Pin-On-Disk friction measuring device. A shaft was rotated at a speed of 300 rpm for 30 minutes. A ball of made of Al₂O₃ was pressed against the rotating surface with a load of 100-500 g.

Corrosion and friction tests were made with the same testing parameters to compare the new coating to other commercial references.

Table 1 shows the hardness, wear depth and friction coefficient measured from three commercial products (A, B, C) and the same properties measured from a coating according to the present invention (D). POD wear tests were carried out with an aluminum oxide ball of 200 g at a speed of 300 rpm. In the wear test of the new coating the Al₂O₃ ball was worn out whereas the coating remained intact.

**TABLE 1**

| | Coating | Hardness HV | Wear depth µm | Friction coefficient | Coating thickness µm |
|---|---|---|---|---|---|
| A | Hard chrome | 950 | 0.6 | 0.38 | 40 |
| B | Thermal spraying 7505 | 1300 | 0.45 | 0.7 | 300 |
| C | Black nitration | 500 | 2 | 0.5 | |
| D | 700°C/30 min + 400°C 30 min | 2400 | 0 | 0.14 | 20 |

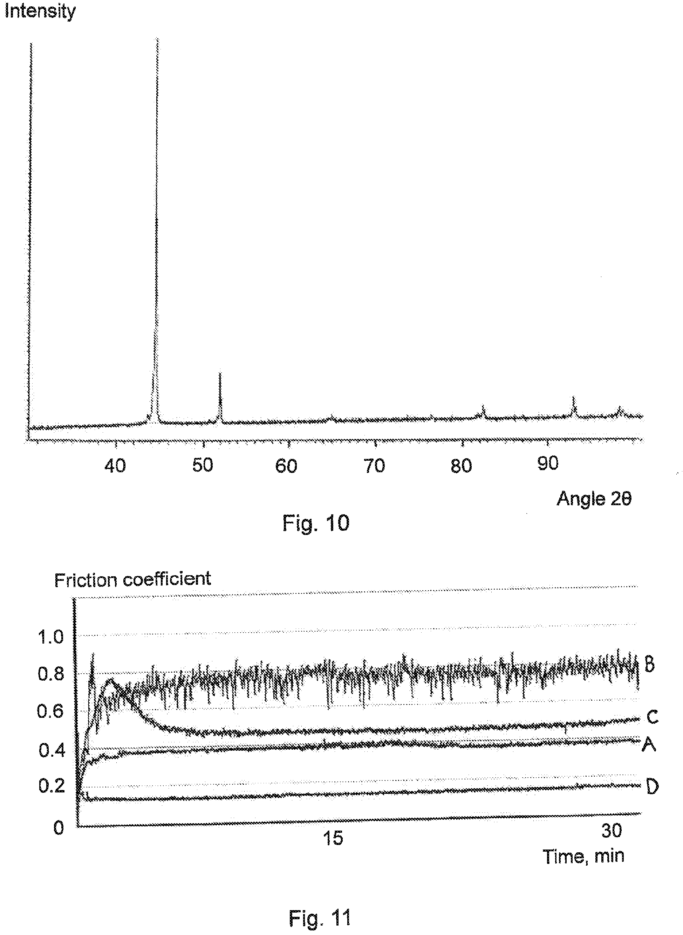

The difference between the friction coefficient of the new coating D and that of the reference coatings A, B and C also illustrated in Fig. 11.

The results of the tests indicate that the hardness of the coating increases as the temperature of the first heating step is raised from 200°C to 700°C. If the process comprises only one heating step, a temperature between 400°C and 600°C gives hardness values between 1600 and 1900 HV. By comparison, when using processes of the prior art, the maximum attainable hardness values are about 1800 HV.

It was discovered that the second heating step further increases the hardness received in the first heating step. Hardness values well over 2000 HV could be measured, the highest values being as high as 2500-3000 HV. It was also discovered that the duration of the second heat treatment should be optimized based on the temperature used in the first heat treatment in order to reach the maximum hardness.

Two optimal combinations of duplex heat treatments could be experimentally identified.

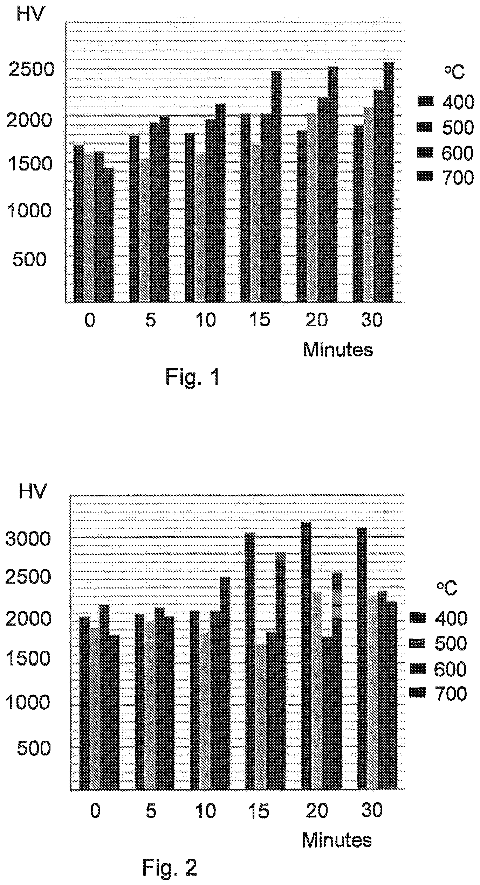

Fig. 1 shows hardness values of the new coating as a function of the length and temperature of the second step of a duplex heat treatment. The first step lasted 45 minutes at 400°C. The second step was carried out at temperatures of 400°C, 500°C, 600°C and 700°C. The treatment in each temperature lasted 5, 10, 15, 20 or 30 minutes. Hardness values were also measured after the first step, indicated as 0 minutes in the graph.

Good results could be achieved by a combination of a first step at 400°C and a second step at 700°C. Hardness values of about 2500 HV were measured after the second step carried out at 700°C with a duration of 15-30 minutes.

Fig. 2 shows in a similar way the hardness values of the new coating. In this case the first step lasted 30 minutes at 700°C. The second step was carried out at temperatures of 400°C, 500°C, 600°C and 700°C. The treatment in each temperature lasted 5, 10, 15, 20 or 30 minutes. Hardness values were also measured after the first step, indicated as 0 minutes in the graph.

Good results could be achieved by a combination of the first step at 700°C and the second step at 400°C. Hardness values of about 3000 HV were measured after the second step carried out at 400°C with a duration of 15-30 minutes.

Fig. 9 shows a SEM micrograph of the cross-section of a coated surface. Cross-sectional views taken from coatings according to the present invention verified the existence of three or four different layers in the coating. The heat treatment of a coated metal substrate affects the Ni-P containing layer and the Cr containing layer, creating various phases within and between the coating layers as a result of diffusion, which phases improve the performance of the plating, for instance, against mechanical exertion. Hyper ternary multiphase alloy contains new extremely hard structures created during the heat treatment.

It could be verified that with a thin layer of Cr, preferably less than 10 pm, and a suitable duplex heat treatment sequence, plated metal surfaces with low friction coefficient and very high hardness can be produced.

### EXAMPLE 2

A steel substrate was coated with a layer of Ni-P with a thickness of 7 µm and a layer of Cr with a thickness of 4 pm. Heat treatment was carried out in two steps: the first step took 45 minutes at 400°C and the second step took 30 minutes at 700°C.

The hardness values measured from the coating after the duplex heat treatment were about 2500 HV, measured with a load of 10 g.

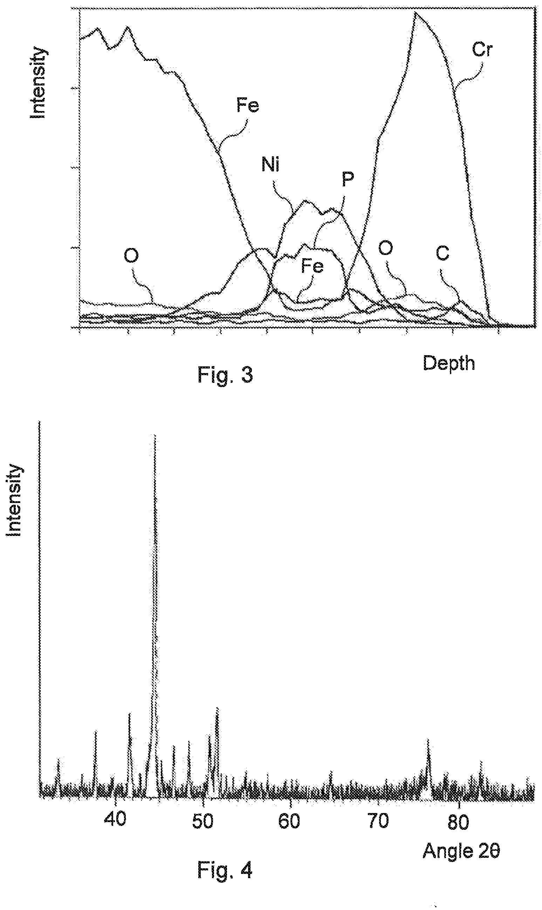

A layered structure could be identified in a cross-sectional micrograph of the coated surface. The composition of the coating was analyzed by energy-dispersive X-ray spectroscopy (EDS) by having an electron beam follow a line on the sample image and generating a plot of the relative proportions of previously identified elements along that spatial gradient. Fig. 3 shows the EDS spectrum of the sample. On the left there is the steel substrate. On the right there is the outer surface of the coating.

The following layers can be identified in the sample, proceeding from the steel substrate toward the outer surface of the coating:
- a layer rich in Fe (steel substrate),
- a layer mainly containing Fe and Ni,
- a layer mainly containing Ni and P,
- a layer mainly containing Ni and Cr,
- a layer mainly containing Cr and O,
- a layer mainly containing Cr and C.

Also the X-ray diffraction spectrum (XRD) of the sample was measured. Fig. 4 shows a part of the XRD spectrum of the sample.

### EXAMPLE 3

Another steel substrate was coated with a similar coating as in Example 2: a layer of nickel phosphorus with a thickness of 7 µm and a layer of chromium with a thickness of 4 pm. Heat treatment was carried out in two steps: the first step took 30 minutes at 400°C and the second step took 30 minutes at 700°C.

The hardness values measured from the coated and heat treated metal substrate were about 2500-3000 HV, measured with a load of 10 g.

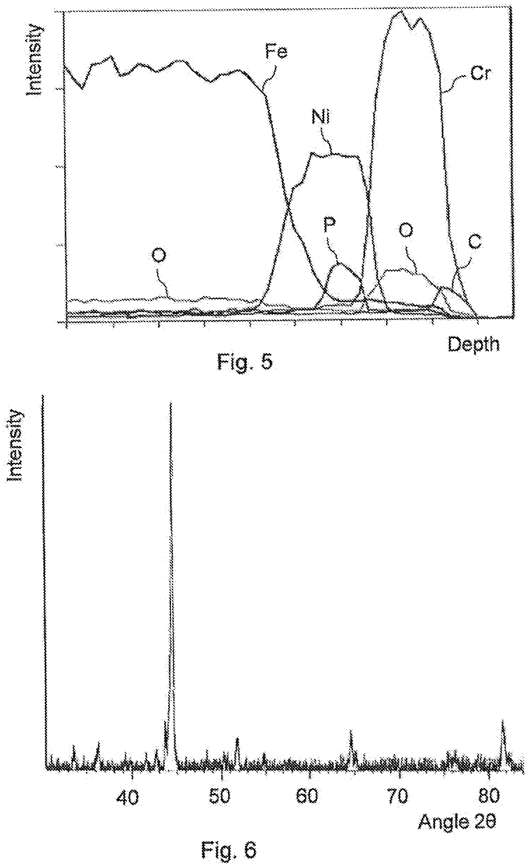

A layered structure could be identified in a cross-sectional micrograph of the coating. Fig. 5 shows the EDS of the sample. The following layers can be identified in the sample, proceeding from the steel substrate toward the outer surface of the coating:
- a layer rich in Fe (steel substrate),
- a layer mainly containing Fe and Ni,
- a layer mainly containing Ni and P,
- a layer mainly containing Ni and Cr,
- a layer mainly containing Cr and O,
- a layer mainly containing Cr and C.

Fig. 6 shows a part of the XRD spectrum of the sample.

The XRD spectra of Fig. 4 (400°C + 700°C) and Fig. 6 (700°C + 400°C) indicate that, in both cases, there are crystalline phases present in the coating. For the sake of comparison, Fig. 10 illustrates the XRD spectrum of a reference sample of the present state of the art, comprising a steel substrate coated with nickel and trivalent chromium and heat treated. The hardness of this sample is 1800 HV. It is evident that the spectra of Fig. 4 and Fig. 6 differ from the spectrum of Fig. 10.

### EXAMPLE 4

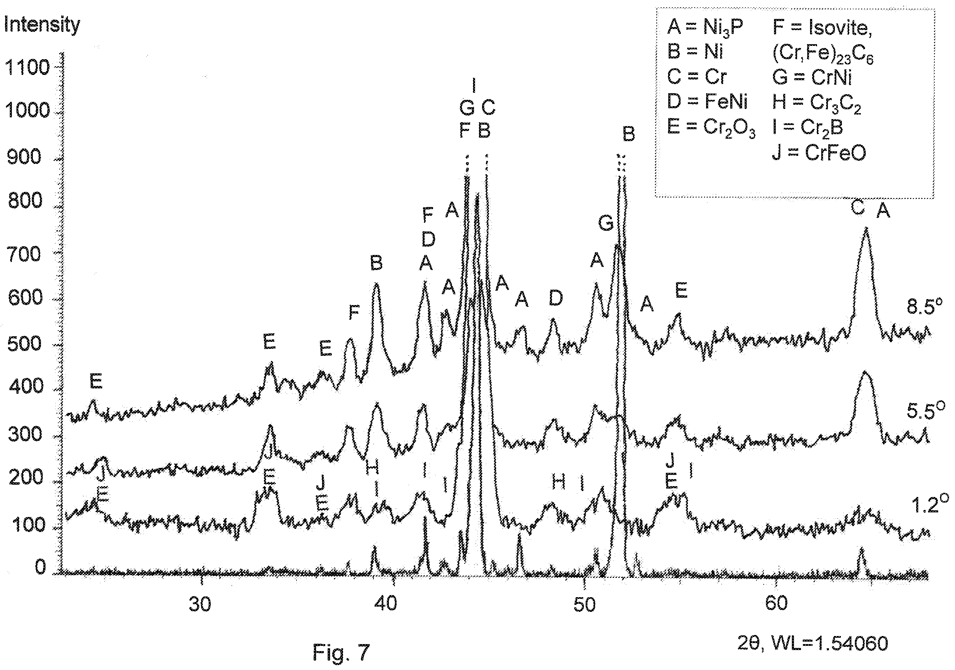

Grazing incidence diffraction (GID) was used to get a near-surface depth profile of the phase structure of the coated surface. The results are shown in Fig. 7, with the conventional XRD spectrum on the bottom. The incident angles 1.2°, 5.5° and 8.5° represent different depths of the coating. Peaks of the XRD spectra measured with different incident angles were identified by comparing the measured spectra with the spectra of the elements known to be contained in the coated substrate.

The XRD spectra of the coated surface contain two higher peaks and several lower peaks. The first peak is located close to a diffraction angle 2θ of 44-45°, corresponding to crystalline phases of Ni₃P, Ni and Cr. There are also traces of crystalline isovite (Cr,Fe)₂₃C₆, CrNi and Cr₂B in the coating. The second peak is located close to a diffraction angle 2θ of 51-52°, corresponding to crystalline phases of Ni and CrNi. Additionally, there is evidence of crystalline phases of Cr₂O₃, Cr₃C₂, Cr₂B and CrFeO in the layers close to the surface. Deeper in the coating there is evidence of crystalline phases of Ni₃P, Ni, Cr, FeNi, Cr₂O₃ and CrNi. The presence of CrNi could also be detected in the EDS measurements (energy-dispersive X-ray spectroscopy, see example 2).

### EXAMPLE 5

A hardenable or surface-hardened metal object was coated with a strike nickel layer of 1 um, a Ni-P layer of 3 µm and a Cr layer of 4 µm. The total thickness of the coating was about 8 um. After this the object was heat-treated by induction heating.

First the object was pre-heated by means of an induction loop with a power of 26 kW and a speed of 1500 mm/min. Then the temperature of the object surface was raised up to 850°C by induction with a power of 26 kW and a speed of 1500 mm/min, after which the object was cooled with water jet.

The surface of the base material was hardened into the depth of about 1 mm and the hardness of the coating increased. The Rockwell hardness of the base material after hardening was 58 HRC and the Vickers microhardness of the coating was about 1800 HV.

### EXAMPLE 6

A hardenable metal object was coated with a strike nickel layer of 1 um, a Ni-P layer of 3 um and Cr layer of 4 um. The total thickness of the coating was about 8 µm. After this the object was heat-treated by induction heating in one step.

The temperature of the object surface was raised up to 850°C by induction with a power of 60 kW and a speed of 1500 mm/min, after which the object was cooled with water jet.

The base material was hardened and the hardness of the coating increased. The Rockwell hardness of the base material after hardening was 55 HRC and the Vickers microhardness of the coating was about 1600 HV.

### EXAMPLE 7

An object was coated with a Ni-P layer of 7 µm and a Cr layer of 5 µm. The coated object was heated at 700°C for 30 minutes. After this a top layer of DLC (diamond like carbon) was deposited on the coated object by thin film deposition.

The coating was very hard. The Pin-on-Disc sliding wear of the coated surface was 0 µm (test conditions: 210 min, 500 g load and 300 rpm). The friction coefficient of the coated surface was 0.24. The AASS corrosion test gave a value of over 200 h.

Alternatively, the top layer could also have been applied directly on the Ni-P,Cr coating, in which case the heat treatment could have been carried out after the thin film deposition step.

It is obvious to a person skilled in the art that with the advancement of technology, the basic idea of the invention may be implemented in various ways. The invention and its embodiments are thus not limited to the examples described above; instead they may vary within the scope of the claims.

## Claims

1. A method for producing a trivalent chromium based coating on a metal substrate, comprising the steps of:
- depositing a layer of nickel phosphorus alloy on a metal substrate;
- electroplating a chromium layer on the layer of Ni-P; and
- subjecting the coated metal substrate to one or more heat treatments to harden the coating to have a Vickers microhardness of 1000-3000 HV and to produce multiphase layers including at least one layer containing crystalline Ni and crystalline Ni₃P and at least one layer containing crystalline Cr and crystalline CrNi, **characterized in that** the chromium layer is electroplated from a trivalent chromium bath.

2. A method according to claim 1, further comprising the step of electroplating a nickel underlayer on the metal substrate before the step of depositing the Ni-P layer; or further comprising the step of electroplating an intermediate layer of nickel between the Ni-P layer and the Cr layer.

3. A method according to any one of claims 1 to 2, comprising two or more heat treatments of the coated metal substrate.

4. A method according to any one of claims 1 to 3, wherein the Ni-P layer is deposited on the metal substrate by electroless plating or electroplating.

5. A method according to any one of claims 1 to 4, wherein the phosphorus content of the Ni-P alloy is in the range of 3-12%, preferably 5-9%.

6. A method according to any one of claims 1 to 5, wherein the thickness of the Ni-P layer is 1-50 pm, preferably 3-30 pm.

7. A method according to any one of claims 1 to 6, wherein the thickness of the Cr layer is 0.05-100 pm, preferably 0.3-5 pm.

8. A method according to claim 3, wherein the temperature in the first heat treatment is 200-500°C, preferably 350-450°C, and the temperature in the second heat treatment is 500-800°C, preferably 650-750°C; or wherein the temperature in the first heat treatment is 500-800°C, preferably 650-750°C, and the temperature in the second heat treatment is 200-500°C, preferably 350-450°C.

9. A method according to claim 1 for producing a decorative and corrosion resistant coating on a metal substrate, comprising the steps of:
- depositing a layer of bright Ni on the metal substrate;
- depositing a layer of Ni-P on the layer of bright Ni;
- electroplating a chromium layer from a trivalent chromium bath on the layer of Ni-P; and
- subjecting the coated metal substrate to a heat treatment at 200-500°C for 15-30 minutes.

10. A method according to claim 1 for producing a multilayer coating on a metal substrate, comprising repeating at least once the steps of depositing a layer of nickel phosphorus alloy and electroplating a chromium layer from a trivalent chromium bath, after which the coated metal substrate is subjected to the said one or more heat treatments.

11. A method according to claim 10, further comprising the step of depositing a strike layer on the layer of trivalent chromium before depositing a new layer of nickel phosphorus alloy.

12. A method according to claim 10 or 11, further comprising the step of depositing an intermediate layer between the layers of Ni-P and Cr, the intermediate layer consisting of another metal or metal alloy or ceramic.

13. A method according to any one of claims 1 to 7 or 10 to 12, wherein at least one of the heat treatments is carried out at a temperature which leads to hardening of the metal substrate at the same time as the coating is hardened.

14. A method according to any one of claims 1 to 13, further comprising the step of depositing a top layer on the coated metal substrate using thin film deposition, such as physical vapor deposition (PVD), chemical vapor deposition (CVD) or atomic layer deposition (ALD).

## Patentansprüche

1. Verfahren zur Herstellung einer Beschichtung auf Basis von dreiwertigem Chrom auf einem Metallsubstrat, umfassend die Schritte:
- Abscheiden einer Schicht aus einer Nickel-Phosphor-Legierung auf ein Metallsubstrat;
- Galvanisieren einer Chromschicht auf die Ni-P-Schicht und
- Unterziehen des beschichteten Metallsubstrats einer oder mehreren Wärmebehandlungen, um die Beschichtung zu härten, so dass sie eine Vickers-Mikrohärte von 1000-3000 HV aufweist, und um mehrphasige Schichten zu erzeugen, die mindestens eine Schicht, die kristallines Ni und kristallines Ni₃P enthält, und mindestens eine Schicht, die kristallines Cr und kristallines CrNi enthält, umfassen,
**dadurch gekennzeichnet, dass** die Chromschicht aus einem dreiwertigen Chrombad galvanisiert wird.

2. Verfahren nach Anspruch 1, ferner umfassend den Schritt des Galvanisierens einer Nickelunterschicht auf das Metallsubstrat vor dem Schritt des Abscheidens der Ni-P-Schicht; oder ferner umfassend den Schritt des Galvanisierens einer Zwischenschicht aus Nickel zwischen der Ni-P-Schicht und der Cr-Schicht.

3. Verfahren nach einem der Ansprüche 1 bis 2, umfassend zwei oder mehr Wärmebehandlungen des beschichteten Metallsubstrats.

4. Verfahren nach einem der Ansprüche 1 bis 3, wobei die Ni-P-Schicht durch stromloses Plattieren oder Galvanisieren auf das Metallsubstrat abgeschieden wird.

5. Verfahren nach einem der Ansprüche 1 bis 4, wobei der Phosphorgehalt der Ni-P-Legierung im Bereich von 3-12 %, vorzugsweise 5-9 %, liegt.

6. Verfahren nach einem der Ansprüche 1 bis 5, wobei die Dicke der Ni-P-Schicht 1-50 pm, vorzugsweise 3-30 pm, beträgt.

7. Verfahren nach einem der Ansprüche 1 bis 6, wobei die Dicke der Cr-Schicht 0,05-100 pm, vorzugsweise 0,3-5 pm, beträgt.

8. Verfahren nach Anspruch 3, wobei die Temperatur bei der ersten Wärmebehandlung 200-500 °C, vorzugsweise 350-450 °C, und die Temperatur bei der zweiten Wärmebehandlung 500-800 °C, vorzugsweise 650-750 °C, beträgt; oder wobei die Temperatur bei der ersten Wärmebehandlung 500-800 °C, vorzugsweise 650-750 °C, und die Temperatur bei der zweiten Wärmebehandlung 200-500 °C, vorzugsweise 350-450 °C, beträgt.

9. Verfahren nach Anspruch 1 zur Herstellung einer dekorativen und korrosionsbeständigen Beschichtung auf einem Metallsubstrat, umfassend die Schritte:
- Abscheiden einer Schicht aus glänzendem Ni auf das Metallsubstrat;
- Abscheiden einer Schicht aus Ni-P auf die Schicht aus glänzendem Ni;
- Galvanisieren einer Chromschicht aus einem dreiwertigen Chrombad auf die Ni-P-Schicht und
- Unterziehen des beschichteten Metallsubstrats einer Wärmebehandlung bei 200-500 °C für 15-30 Minuten.

10. Verfahren nach Anspruch 1 zur Herstellung einer mehrlagigen Beschichtung auf einem Metallsubstrat, umfassend das mindestens einmalige Wiederholen der Schritte des Abscheidens einer Schicht aus einer Nickel-Phosphor-Legierung und des Galvanisierens einer Chromschicht aus einem dreiwertigen Chrombad, wonach das beschichtete Metallsubstrat der einen oder den mehreren Wärmebehandlungen unterzogen wird.

11. Verfahren nach Anspruch 10, ferner umfassend den Schritt des Abscheidens einer Schlagschicht auf die Schicht aus dreiwertigem Chrom vor dem Abscheiden einer neuen Schicht aus der Nickel-Phosphor-Legierung.

12. Verfahren nach Anspruch 10 oder 11, ferner umfassend den Schritt des Abscheidens einer Zwischenschicht zwischen den Schichten aus Ni-P und Cr, wobei die Zwischenschicht aus einem anderen Metall oder einer Metalllegierung oder Keramik besteht.

13. Verfahren nach einem der Ansprüche 1 bis 7 oder 10 bis 12, wobei mindestens eine der Wärmebehandlungen bei einer Temperatur durchgeführt wird, die zu einer Härtung des Metallsubstrats führt, während gleichzeitig die Beschichtung gehärtet wird.

14. Verfahren nach einem der Ansprüche 1 bis 13, ferner umfassend den Schritt des Abscheidens einer Deckschicht auf das beschichtete Metallsubstrat unter Verwendung einer Dünnschichtabscheidung, wie physikalischer Gasphasenabscheidung (PVD), chemischer Gasphasenabscheidung (CVD) oder Atomlagenabscheidung (ALD).

## Revendications

1. Procédé de production d'un revêtement à base de chrome trivalent sur un substrat métallique, comprenant les étapes de :
- dépôt d'une couche d'alliage de phosphore et de nickel sur un substrat métallique ;
- dépôt électrolytique d'une couche de chrome sur la couche de Ni-P ; et
- soumission du substrat métallique revêtu à un ou plusieurs traitements thermiques pour durcir le revêtement pour qu'il présente une microdureté de Vickers de 1000 à 3000 HV et pour produire des couches multiphasiques incluant au moins une couche contenant du Ni cristallin et du Ni₃P cristallin et au moins une couche contenant du Cr cristallin et du CrNi cristallin, **caractérisé en ce que** la couche de chrome est soumise à un dépôt électrolytique à partir d'un bain de chrome trivalent.

2. Procédé selon la revendication 1, comprenant en outre l'étape de dépôt électrolytique d'une sous-couche de nickel sur le substrat métallique avant l'étape de dépôt de la couche de Ni-P ; ou comprenant en outre l'étape de dépôt électrolytique d'une couche intermédiaire de nickel entre la couche de Ni-P et la couche de Cr.

3. Procédé selon l'une quelconque des revendications 1 à 2, comprenant deux traitements thermiques ou plus du substrat métallique revêtu.

4. Procédé selon l'une quelconque des revendications 1 à 3, dans lequel la couche de Ni-P est déposée sur le substrat métallique par dépôt autocatalytique ou dépôt électrolytique.

5. Procédé selon l'une quelconque des revendications 1 à 4, dans lequel la teneur en phosphore de l'alliage de Ni-P est dans la plage de 3 à 12 %, de préférence de 5 à 9 %.

6. Procédé selon l'une quelconque des revendications 1 à 5, dans lequel l'épaisseur de la couche de Ni-P est de 1 à 50 pm, de préférence de 3 à 30 µm.

7. Procédé selon l'une quelconque des revendications 1 à 6, dans lequel l'épaisseur de la couche de Cr est de 0,05 à 100 pm, de préférence de 0,3 à 5 µm.

8. Procédé selon la revendication 3, dans lequel la température dans le premier traitement thermique est de 200 à 500 °C, de préférence de 350 à 450 °C, et la température dans le second traitement thermique est de 500 à 800 °C, de préférence de 650 à 750 °C ; ou dans lequel la température dans le premier traitement thermique est de 500 à 800 °C, de préférence de 650 à 750 °C, et la température dans le second traitement thermique est de 200 à 500 °C, de préférence de 350 à 450 °C.

9. Procédé selon la revendication 1 pour produire un revêtement décoratif et résistant à la corrosion sur un substrat métallique, comprenant les étapes de :
- dépôt d'une couche de Ni brillant sur le substrat métallique ;
- dépôt d'une couche de Ni-P sur la couche de Ni brillant ;
- dépôt électrolytique d'une couche de chrome à partir d'un bain de chrome trivalent sur la couche de Ni-P ; et
- soumission du substrat métallique revêtu à un traitement thermique à 200 à 500 °C pendant 15 à 30 minutes.

10. Procédé selon la revendication 1 pour produire un revêtement multicouche sur un substrat métallique, comprenant la répétition au moins une fois des étapes de dépôt d'une couche d'alliage de phosphore et de nickel et de dépôt électrolytique d'une couche de chrome à partir d'un bain de chrome trivalent, après quoi le substrat métallique revêtu est soumis auxdits un ou plusieurs traitements thermiques.

11. Procédé selon la revendication 10, comprenant en outre l'étape de dépôt d'une couche de solution d'amorçage sur la couche de chrome trivalent avant le dépôt d'une nouvelle couche d'alliage de phosphore et de nickel.

12. Procédé selon la revendication 10 ou la revendication 11, comprenant en outre l'étape de dépôt d'une couche intermédiaire entre les couches de Ni-P et de Cr, la couche intermédiaire consistant en un autre métal ou alliage de métaux ou céramique.

13. Procédé selon l'une quelconque des revendications 1 à 7 ou des revendications 10 à 12, dans lequel au moins l'un des traitements thermiques est mis en oeuvre à une température qui conduit au durcissement du substrat métallique en même temps que le revêtement est durci.

14. Procédé selon l'une quelconque des revendications 1 à 13, comprenant en outre l'étape de dépôt d'une couche supérieure sur le substrat métallique revêtu en utilisant un dépôt de couches minces, tel qu'un dépôt physique en phase vapeur (PVD), un dépôt chimique en phase vapeur (CVD) ou un dépôt de couche atomique (ALD).
